# EUROPEAN PATENT APPLICATION

(11) **EP 4 672 434 A1**
(43) Date of publication of application: **31.12.2025**
(21) Application number: 24838581.7
(22) Date of filing: 25.06.2024
(51) Int. Cl.: H01M 10/6568, H05K 7/20, H01M 10/613

(54) **COOLING SYSTEM AND ENERGY STORAGE POWER STATION**

(30) Priority: 12.07.2023 CN 202310850376
(71) Applicant: Contemporary Amperex Technology Co., Limited, Ningde, Fujian 352100 (CN)
(72) Inventor: LI, Xin, Ningde, Fujian 352100 (CN); CHEN, Xiaobo, Ningde, Fujian 352100 (CN); WANG, Xuehui, Ningde, Fujian 352100 (CN)
(74) Representative: Lorenz Seidler Gossel Part. mbB
(86) International application number: PCT/CN2024/101160
(87) International publication number: WO 2025/011325

(57) **Abstract**

The present application applies to the technical field of cooling. Provided are a cooling system (100) and an energy storage power station. The energy storage power station comprises a cooling system (100), the cooling system (100) comprising a plurality of cooling loops (101) and a plurality of heating modules (20), wherein the plurality of cooling loops (101) are separately arranged, and the plurality of heating modules (20) are respectively arranged on the plurality of cooling loops (101), the plurality of cooling loops (101) respectively being used for cooling the heating modules (20). Such an arrangement enables the cooling system (100) to cool the plurality of heating modules (20) by means of the plurality of cooling loops (101). Moreover, the plurality of cooling loops (101) can be separately arranged, so that each cooling loop (101) is adapted for passage of a cooling liquid with a corresponding flow rate and pressure, thereby matching a corresponding heating module (20), enabling the corresponding heating module (20) to be cooled. In this way, the cooling system (100) enables the flow rate and pressure of the cooling liquid passing through each heating module (20) to match said heating module (20), thus helping to achieve a good cooling effect on the plurality of heating modules (20).

## Description

### CROSS-REFERENCE

The present application claims priority to Chinese Patent Application No. 202310850376.0 filed with China National Intellectual Property Administration on July 12, 2023 and entitled "COOLING SYSTEM AND ENERGY STORAGE POWER STATION", which is incorporated herein by reference in its entirety.

### TECHNICAL FIELD

The present application relates to the technical field of cooling, and in particular, to a cooling system and an energy storage power station.

### BACKGROUND

The cooling system refers to a device for cooling heat generating modules by means of a coolant liquid. In the related art, when the cooling system is used for cooling a plurality of heat generating modules, the coolant liquid in the cooling system generally passes through the plurality of heat generating modules at a predetermined pressure and flow rate to cool the plurality of heat generating modules. However, the required coolant liquid pressure and flow rate vary among different heat generating modules. As such, it is difficult to match the pressure and flow rate of the coolant liquid with the plurality of heat generating modules.

### SUMMARY

In view of the above problem, an objective of embodiments of the present application is to provide a cooling system and an energy storage power station, such that the problem that it is difficult to match the pressure and flow rate of a coolant liquid with a plurality of heat generating modules can be alleviated.

The technical solutions used in the embodiments of the present application are as follows:

According to a first aspect, an embodiment of the present application provides a cooling system. The cooling system includes:
a plurality of cooling loops, arranged independent from each other; and
a plurality of heat generating modules, respectively arranged in the plurality of cooling loops, where the plurality of cooling loops are respectively configured to cool the heat generating modules.

According to the cooling system provided in the embodiment of the present application, by arranging the plurality of cooling loops independent from each other and the plurality of heat generating modules respectively arranged in the plurality of cooling loops and configuring the plurality of cooling loops to respectively cool the heat generating modules, the cooling system can implement cooling for the plurality of heat generating modules through the plurality of cooling loops. In addition, the plurality of cooling loops may be separately arranged, such that each cooling loop is configured to allow a coolant liquid at a corresponding flow rate and pressure to pass through so as to match a corresponding heat generating module, thereby being capable of cooling the corresponding heat generating module. As such, the cooling system enables the flow rate and pressure of the coolant liquid passing through each heat generating module to match the heat generating module, which facilitates achieving a good cooling effect for the plurality of heat generating modules.

In some embodiments, the cooling system further includes a heat exchange loop independent from the cooling loops, and the heat exchange loop is configured to exchange heat with each cooling loop.

By allowing the plurality of cooling loops of the cooling system to share one heat exchange loop, the number of devices of the cooling system can be reduced, thereby being capable of reducing the floor space of the cooling system, which in turn can reduce the failure rate of the cooling system and reduce the manufacturing and maintenance costs of the cooling system.

In some embodiments, the cooling system further includes a heat exchange apparatus, and the heat exchange apparatus is arranged in the cooling loop and the heat exchange loop for the cooling loop and the heat exchange loop to exchange heat in the heat exchange apparatus.

Due to such an arrangement, the heat exchange loop and the cooling loop are enabled to exchange heat in the heat exchange apparatus, such that the cooling loop can continuously implement cooling for the heat generating module.

In some embodiments, the heat exchange apparatus includes a plurality of first heat exchangers, the first heat exchanger is provided with a first flow channel and a second flow channel that are independent from each other, the first flow channel is configured to form the cooling loop, and the second flow channels of the plurality of first heat exchangers are configured to form the heat exchange loop.

Due to such an arrangement, the heat exchange loop is enabled to exchange heat with each cooling loop, such that each cooling loop can continuously implement cooling for the corresponding heat generating module.

In some embodiments, a flow direction of the coolant liquid in the first flow channel is opposite to a flow direction of a heat exchange medium in the second flow channel.

As such, the coolant liquid is enabled to better exchange heat with the heat exchange medium, thereby facilitating improving the heat exchange efficiency and effect.

In some embodiments, the first flow channel and the second flow channel are sequentially distributed in a thickness direction of the first heat exchanger.

As such, the first flow channel and the second flow channel are enabled to have a larger heat exchange area, which thus can improve the heat exchange efficiency and heat exchange effect.

In some embodiments, the heat exchange apparatus includes a second heat exchanger, the second heat exchanger is provided with a third flow channel and a plurality of fourth flow channels that are independent from each other, the third flow channel is configured to form the heat exchange loop, and the fourth flow channel is configured to form the cooling loop.

Due to such an arrangement, the heat exchange loop is enabled to exchange heat with each cooling loop, such that each cooling loop can continuously implement cooling for the corresponding heat generating module. In addition, by arranging only one second heat exchanger, the heat-exchange cooling effect of the heat exchange loop for the plurality of cooling loops can be achieved, such that the structure of the cooling system is enabled to be very simple.

In some embodiments, a flow direction of a coolant liquid in the fourth flow channel is opposite to a flow direction of a heat exchange medium in the third flow channel.

As such, the coolant liquid is enabled to better exchange heat with the heat exchange medium, thereby facilitating improving the heat exchange efficiency and effect.

In some embodiments, the heat exchange apparatus and the heat generating module form the cooling loop;
alternatively, the cooling system further includes a third heat exchanger, the heat exchange apparatus and the third heat exchanger form the cooling loop, and the third heat exchanger is configured to exchange heat with the heat generating module.

Due to such an arrangement, the cooling loop is enabled to implement cooling for the heat generating module.

In some embodiments, two of the heat generating modules are a first heat generating module and a second heat generating module, respectively, the first heat generating module includes a battery, and the second heat generating module includes a converter.

Due to such an arrangement, the cooling system is enabled to be configured to cool the battery and the converter, and the battery and the converter may be cooled through different cooling loops. In this way, the flow rate and pressure of the coolant liquid required by the battery can match those of the coolant liquid in a corresponding cooling loop, and the flow rate and pressure of the coolant liquid required by the converter can also match those of the coolant liquid in the corresponding cooling loop, thereby being capable of alleviating the problem that it is difficult to match the pressure and flow rate of the coolant liquid with the plurality of heat generating modules, and facilitating achieving a good cooling effect for the battery and the converter.

In some embodiments, two of the cooling loops are a first cooling loop and a second cooling loop, respectively, the first heat generating module is arranged in the first cooling loop, and the second heat generating module is arranged in the second cooling loop;
the cooling system further includes a heat exchange loop independent from the cooling loops, and the heat exchange loop is configured to exchange heat with each cooling loop;
the first cooling loop and the second cooling loop are sequentially arranged in a circulation direction of the heat exchange medium in the heat exchange loop.

In this way, compared with the second cooling loop, the coolant liquid in the first cooling loop can exchange heat with the heat exchange medium having a lower temperature, such that the cooling operation for the battery can be better achieved.

In some embodiments, the heat generating module includes a plurality of heat generating elements, and the plurality of heat generating elements are arranged in the cooling loop in parallel through pipelines.

Due to such an arrangement, the coolant liquid in the cooling loop is enabled to flow in parallel to the plurality of heat generating elements to cool the plurality of heat generating elements, thereby being capable of improving the effect of the cooling loop in cooling the heat generating module.

In some embodiments, the heat exchange loop is provided with a cooling tower.

In this way, when circulating in the heat exchange loop, the heat exchange medium can be continuously cooled by the cooling tower and exchange heat with the cooling loop, such that heat-exchange cooling for the cooling loop can be continuously implemented, thereby being beneficial for the coolant liquid in the cooling loop to continuously implement cooling for the heat generating module.

In some embodiments, the cooling loop and/or the heat exchange loop are/is provided with at least one of a pumping apparatus, a flow meter, a water replenishing apparatus, a pressure gauge, a gas pressure balancing apparatus, and an ion exchanger.

Due to such an arrangement, the cooling loop is enabled to stably implement the cooling operation for the heat generating module, and/or the heat exchange loop is enabled to stably implement heat exchange with the cooling loop, such that the cooling system can stably implement the cooling operation for the heat generating module.

In a second aspect, an embodiment of the present application provides an energy storage power station. The energy storage power station includes a cooling system.

According to the energy storage power station provided in the embodiment of the present application, by adopting the cooling system involved above, both a flow rate and pressure of a coolant liquid passing through each heat generating module can match the heat generating module; that is, the problem that it is difficult to match the pressure and flow rate of the coolant liquid with a plurality of heat generating modules can be alleviated, thereby facilitating achieving a good cooling effect for the plurality of heat generating modules.

The above description is only an overview of the technical solutions of the present application. To more clearly understand the technical means of the present application to enable implementation in accordance with the content of the specification and to make the above and other purposes, features, and advantages of the present application more obvious and easy to understand, the detailed description of the present application is provided below.

### BRIEF DESCRIPTION OF THE DRAWINGS

To more clearly illustrate the technical solutions in embodiments of the present application, the drawings required for illustrating the embodiments or exemplary technologies are briefly described below. Apparently, the drawings in the following description illustrate merely some embodiments of the present application, and those of ordinary skill in the art may still derive other drawings from these drawings without creative efforts.
FIG. 1 is a schematic view of a cooling system according to some embodiments of the present application;
FIG. 2 is a cross-sectional view of a first heat exchanger of a heat exchange apparatus of the cooling system provided in FIG. 1;
FIG. 3 is a schematic view of a cooling system according to some other embodiments of the present application;
FIG. 4 is a cross-sectional view of a second heat exchanger of a heat exchange apparatus of the cooling system provided in FIG. 3; and
FIG. 5 is a schematic view of a treatment apparatus of the cooling system according to some embodiments of the present application.

Reference numerals in the drawings have the following meanings:
100-cooling system; 101-cooling loop; 101a-first cooling loop; 101b-second cooling loop; 102-heat exchange loop; 10-heat exchange apparatus; 11-first heat exchanger; 11a-No. 1 first heat exchanger; 11b-No. 2 first heat exchanger; 1101-first flow channel; 1102-second flow channel; 12-second heat exchanger; 1201-third flow channel; 1202-fourth flow channel; 1202a-No. 1 fourth flow channel; 1202b-No. 2 fourth flow channel; 20-heat generating module; 20a-first heat generating module; 20b-second heat generating module; 21-heat generating element; 22-cooling tower; 23-treatment apparatus; 231-pumping apparatus; 232-water replenishing apparatus; 2321-raw water tank; 2322-water replenishing pump; 233-gas pressure balancing apparatus; 2331-degassing tank; 2332-expansion tank; 234-ion exchanger; 24-first main pipeline; 25-second main pipeline; 26-branch pipeline.

### DETAILED DESCRIPTION

Embodiments of the present application are described in detail hereinafter, with examples of the embodiments illustrated in the drawings. Throughout the drawings, the same or similar reference numbers indicate the same or similar elements or elements having the same or similar functions. The embodiments described hereinafter with reference to the drawings are exemplary and are intended to explain the present application. They should not be construed as limiting the present application.

In the description of the present application, it should be understood that the terms "length", "width", "upper", "lower", "front", "rear", "left", "right", "vertical", "horizontal", "top", "bottom", "inner", "outer", and the like indicate orientations or positional relationships based on those shown in the drawings. They are merely for the convenience of describing the present application and simplifying the description, rather than indicating or implying that the apparatus or element referred to must have a specific orientation or be constructed and operate in the specific orientation, and thus should not be construed as a limitation to the present application.

In addition, the terms "first" and "second" are used for description only and are not to be construed as indicating or implying relative importance or to implicitly indicate the number of technical features indicated. Therefore, a feature defined with "first" or "second" may explicitly or implicitly include one or more such a feature.

In the description of the present application, "a plurality of" means no less than two, and "no less than two" includes two, unless otherwise specifically defined. Correspondingly, "a plurality of groups" means no less than two groups.

In the description of the present application, unless otherwise clearly specified and defined, the terms "mount", "interconnect", "connect", "fix", and the like should be interpreted in their broad senses. For example, "connect" may be "fixedly connect", "detachably connect", or "integrally connect"; "mechanically connect" or "electrically connect"; or "directly interconnect", "indirectly interconnect through an intermediate", "communication between interiors of two elements", or "interaction between two elements". For those of ordinary skill in the art, the specific meanings of the aforementioned terms in the present application can be understood according to specific conditions.

In the description of the present application, the term "and/or" is merely a way to describe the associative relationship between associated objects, indicating that there are three possible relationships. For example, "A and/or B" may denote: the presence of A alone, the presence of both A and B, and the presence of B alone. In addition, the character "/" herein generally indicates an "or" relationship between the associated objects before and after the "/".

Although the present application has been described with reference to preferred embodiments, various modifications can be made and components can be replaced with equivalents without departing from the scope of the present application. In particular, the technical features mentioned in the embodiments can be combined in any manner, provided that there is no structural conflict. The present application is not limited to the specific embodiments disclosed herein, but includes all the technical solutions that fall within the scope of the claims.

The cooling system refers to a device for cooling heat generating modules by means of a coolant liquid.

In the related art, when the cooling system is used for cooling a plurality of heat generating modules, the coolant liquid in the cooling system generally passes through the plurality of heat generating modules at a predetermined pressure and flow rate to cool the plurality of heat generating modules. Specifically, the plurality of heat generating modules are sequentially connected through a cooling pipeline of the cooling system, such that the coolant liquid can sequentially pass through the plurality of heat generating modules to sequentially cool the plurality of heat generating modules. Based on this, the coolant liquid passing through the plurality of heat generating modules has the same pressure and flow rate.

However, the required coolant liquid pressure and flow rate vary among different heat generating modules. As such, it is difficult to match the pressure and flow rate of the coolant liquid with the plurality of heat generating modules.

For example, an energy storage power station usually includes heat generating modules such as a battery, a converter, and an air cooler, all of which generate heat during operation. When the cooling system is applied to the energy storage power station, the cooling system is configured to cool the heat generating modules to maintain normal operation of the energy storage power station.

The heat generating modules such as the battery, the converter, and the air cooler are sequentially connected through the cooling pipeline of the cooling system, such that the coolant liquid in the cooling system can sequentially pass through the heat generating modules such as the battery, the converter, and the air cooler at a predetermined flow rate and pressure.

The battery and the converter are used as an example. First, the conversion efficiency of the battery is generally less than the conversion efficiency of the converter, such that the heat generation power of the battery is greater than the heat generation power of the converter. Second, the temperature rise of the coolant liquid when passing through the battery is generally less than the temperature rise of the coolant liquid when passing through the converter. Based on this, the flow rate of the coolant liquid required by the battery is greater than the flow rate of the coolant liquid required by the converter.

During the discharge of the energy storage power station, the direct current output by the battery is converted into alternating current by the converter, and then the alternating current is connected to the power grid by a transformer.

Assuming that the power of chemical energy consumed by the battery is W1, the power input to the converter is W2, and the power input from the converter to the transformer is W3, then the conversion efficiency of the battery is approximately eb = W2/W1, the heat generation power of the battery is approximately (W1-W2), the conversion efficiency of the converter is approximately ep = W3/W2, and the heat generation power of the converter is approximately (W2-W3).

Assuming that the specific heat capacity of the coolant liquid is Cp, the temperature rise of the coolant liquid of the battery is ΔTb, and the temperature rise of the coolant liquid of the converter is ΔTp, then the flow rate of the coolant liquid required by the battery is Qb = (W1 - W2)/ΔTb/Cp, and the flow rate of the coolant liquid required by the converter is Qp = (W2 - W3)/ΔTp/Cp.

Taking an energy storage power station of 100 MW/200 MWh as an example, W3 ≈ 100 MW, the conversion efficiency eb of the battery is approximately 97%, and the conversion efficiency ep of the converter is approximately 98%, then the heat generation power of the battery is (W1 - W2) = 3.2 MW, and the heat generation power of the converter is (W2 - W3) = 2 MW.

Assuming that the specific heat capacity Cp of the coolant liquid is 4200 J/kg/°C, the temperature rise ΔTb of the coolant liquid of the battery is approximately 3°C, and the temperature rise ΔTp of the coolant liquid of the converter is approximately 10°C, then the flow rate Qb of the coolant liquid required by the battery is 254 kg/s, and the flow rate Qp of the coolant liquid required by the converter is 47.6 kg/s.

As described above, the flow rate of the coolant liquid required by the battery is greater than the flow rate of the coolant liquid required by the converter.

In addition, the pressure of the coolant liquid required by the battery also differs from the pressure of the coolant liquid required by the converter.

However, the coolant liquid in the cooling system passes through the battery and the converter at a predetermined pressure and flow rate, which thus makes it difficult to match the pressure and flow rate of the coolant liquid with both the battery and the converter, consequently making it difficult for the cooling system to well cool the battery and the converter.

Based on the above considerations, the embodiments of the present application provide a cooling system and an energy storage power station. By arranging a plurality of cooling loops independent from each other and a plurality of heat generating modules respectively arranged in the plurality of cooling loops and configuring the plurality of cooling loops to respectively cool the heat generating modules, the cooling system can implement cooling for the plurality of heat generating modules through the plurality of cooling loops. In addition, the plurality of cooling loops may be separately arranged, such that each cooling loop is configured to allow a coolant liquid at a corresponding flow rate and pressure to pass through so as to match a corresponding heat generating module, thereby being capable of cooling the corresponding heat generating module. As such, the cooling system enables the flow rate and pressure of the coolant liquid passing through each heat generating module to match the heat generating module, which facilitates achieving a good cooling effect for the plurality of heat generating modules.

The energy storage power station involved in the embodiments of the present application is a system where a plurality of batteries are gathered together to serve the function of energy storage. The energy storage power station may include a cooling system, and may further include at least two of the heat generating modules such as a battery, a converter, and an air cooler. The cooling system is configured to cool the plurality of heat generating modules.

Although the cooling system involved in the embodiments of the present application is developed based on the problem that it is difficult to match the flow rate and pressure of the coolant liquid in the energy storage power station with the battery and the converter, the application scenario thereof is not limited thereto, and the cooling system is applicable to any scenario that requires cooling. It can be understood that the cooling system involved in the embodiments of the present application may be configured to cool the heat generating modules such as the battery, the converter, and the air cooler of the energy storage power station, or may also be configured to cool the heat generating modules in fields other than the energy storage power station. That is, the plurality of heat generating modules may be the battery, the converter, the air cooler, or the like in the energy storage power station, or may be heat generating modules other than the energy storage power station.

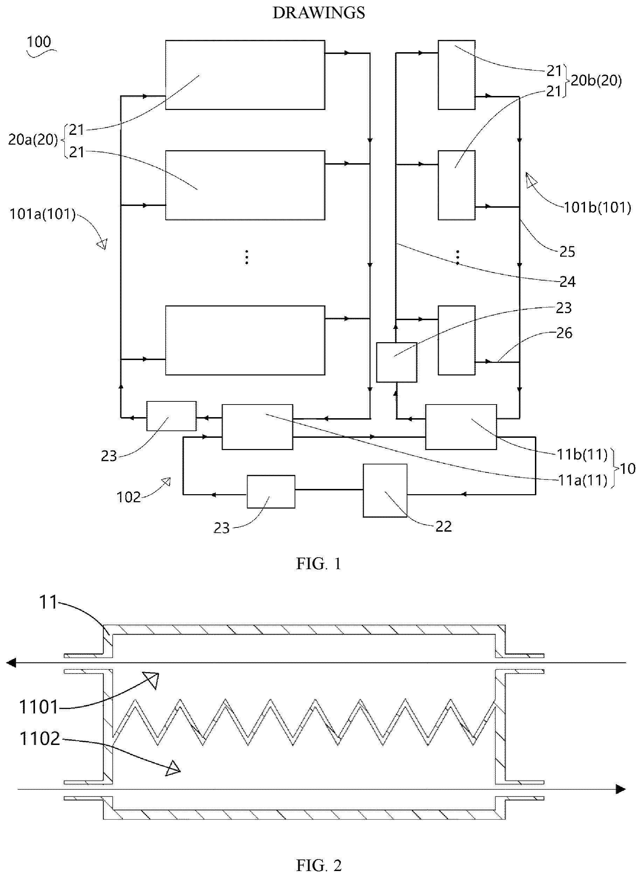

Referring to FIG. 1, FIG. 1 is a schematic view of a cooling system 100 according to some embodiments of the present application. The cooling system 100 provided in the embodiments of the present application includes a plurality of cooling loops 101 and a plurality of heat generating modules 20. The plurality of cooling loops 101 are arranged independent from each other, the plurality of heat generating modules 20 are respectively arranged in the plurality of cooling loops 101, and the plurality of cooling loops 101 are respectively configured to cool the heat generating modules 20.

The cooling loop 101 refers to a loop formed when a coolant liquid continuously circulates to perform cooling in the loop. The heat generating module 20 may be arranged in the cooling loop 101. In this way, during circulation, the coolant liquid may pass through the heat generating module 20 to exchange heat with the heat generating module 20, thereby implementing a cooling effect for the heat generating module 20.

The coolant liquid may be water or other solutions having a cooling function.

The expression that the plurality of cooling loops 101 are arranged independent from each other means that the plurality of cooling loops 101 are not in communication with each other, such that the coolant liquid cannot circulate between the plurality of cooling loops 101.

The plurality of heat generating modules 20 are respectively arranged in the plurality of cooling loops 101, such that one or more heat generating modules 20 are arranged in each cooling loop 101 of the plurality of cooling loops 101; that is, one cooling loop 101 corresponds to one or more heat generating modules 20. Based on this, each cooling loop 101 may cool the corresponding heat generating module 20. As an example, each cooling loop 101 is provided with one heat generating module 20, and each cooling loop 101 is configured to cool each corresponding heat generating module 20.

The heat generating module 20 is arranged in the cooling loop 101, and it may be that the heat generating module 20, a heat exchange apparatus 10, and pipelines of the cooling system 100 form the cooling loop 101, or a third heat exchanger referred to below, the heat exchange apparatus 10, and the pipelines of the cooling system 100 form the cooling loop 101, while the heat generating module 20 does not participate in forming the cooling loop 101.

The cooling system 100 provided in the embodiments of the present application is provided with the plurality of cooling loops 101 independent from each other and the plurality of heat generating modules 20. The plurality of heat generating modules 20 are respectively arranged in the plurality of cooling loops 101, and the plurality of cooling loops 101 are configured to respectively cool the heat generating modules 20. Based on this, one cooling loop 101 may be provided with one or more heat generating modules 20, such that the cooling loop 101 is configured to cool the one or more heat generating modules 20. In this way, the arrangement of the plurality of cooling loops 101 enables the cooling system 100 to implement the cooling operation for the plurality of heat generating modules 20 through the plurality of cooling loops 101.

In addition, the plurality of cooling loops 101 are arranged independent from each other, such that the plurality of cooling loops 101 may be separately arranged, and each cooling loop 101 is configured to allow a coolant liquid at a corresponding flow rate and pressure to pass through. In this way, each cooling loop 101 may be correspondingly arranged according to the flow rate and pressure of the coolant liquid required by the corresponding heat generating module 20, such that the flow rate of the coolant liquid passing through the cooling loop 101 can match the flow rate of the coolant liquid required by the corresponding heat generating module 20, and the pressure of the coolant liquid passing through the cooling loop 101 can also match the pressure of the coolant liquid required by the corresponding heat generating module 20; that is, both the flow rate and pressure of the coolant liquid passing through the cooling loop 101 match the corresponding heat generating module 20, thereby being capable of well cooling the corresponding heat generating module 20.

It can be understood that each cooling loop 101 corresponds to a coolant liquid at a predetermined flow rate and pressure. Based on this, the plurality of heat generating modules 20 that require the same flow rate and pressure of the coolant liquid may be arranged in the same cooling loop 101, or certainly may be respectively arranged in a plurality of cooling loops 101. When two heat generating modules 20 require different flow rates or pressures of the coolant liquid, the two heat generating modules 20 may be correspondingly arranged in two cooling loops 101, respectively, such that each cooling loop 101 cools the corresponding heat generating module 20.

Due to such an arrangement, the cooling system 100 is enabled to match the flow rate and pressure of the coolant liquid passing through each heat generating module 20 with the heat generating module 20; that is, the problem that it is difficult to match the pressure and flow rate of the coolant liquid with the plurality of heat generating modules 20 can be alleviated, thereby facilitating achieving a good cooling effect for the plurality of heat generating modules 20.

In some embodiments, referring further to FIG. 1, the cooling system 100 further includes a heat exchange loop 102. The heat exchange loop 102 and the cooling loop 101 are arranged independent from each other, and the heat exchange loop 102 is configured to exchange heat with each cooling loop 101.

The heat exchange loop 102 refers to a loop formed when a heat exchange medium continuously circulates to perform heat exchange in the loop.

The expression that the heat exchange loop 102 and the cooling loop 101 are arranged independent from each other means that the heat exchange loop 102 and the cooling loop 101 are not in communication with each other, such that the heat exchange medium in the heat exchange loop 102 and the coolant liquid in the cooling loop 101 flow separately without coming into contact or mixing with each other through circulation.

The expression that the heat exchange loop 102 is configured to exchange heat with each cooling loop 101 means that the heat exchange loop 102 can implement cooling of each cooling loop 101, such that the cooling loop 101 can continuously implement cooling for the heat generating module 20.

Based on the above structure, when the cooling system 100 is in operation, the heat exchange medium circulates in the heat exchange loop 102, and the coolant liquid circulates in each cooling loop 101. When the coolant liquid circulates to the heat generating module 20, the coolant liquid exchanges heat with the heat generating module 20 to implement cooling for the heat generating module 20. After the coolant liquid exchanges heat with the heat generating module 20, the coolant liquid will heat up. The heated coolant liquid exchanges heat with the heat exchange medium circulating in the heat exchange loop 102, such that the coolant liquid can be cooled. The cooled coolant liquid continues to circulate to the heat generating module 20 to exchange heat with the heat generating module 20, and so on. In this way, during the circulation process, the coolant liquid continuously exchanges heat with the heat generating module 20 and the heat exchange medium of the heat exchange loop 102, such that the coolant liquid can continuously implement the cooling operation for the heat generating module 20 at a lower temperature.

The heat exchange loop 102 can exchange heat with the plurality of cooling loops 101. That is, the coolant liquid in each cooling loop 101 can be cooled by exchanging heat with the heat exchange medium of the heat exchange loop 102.

The heat exchange medium may be water or other solutions having a cooling function, or may be a gas medium having a cooling function.

By adopting the above technical solutions, the heat exchange loop 102 is enabled to exchange heat with the plurality of cooling loops 101 to implement cooling for the plurality of cooling loops 101. That is, the plurality of cooling loops 101 of the cooling system 100 share one heat exchange loop 102, such that the number of devices in the cooling system 100 can be reduced, thereby being capable of reducing the floor space of the cooling system 100, which in turn can reduce the failure rate of the cooling system 100 and reduce the manufacturing and maintenance costs of the cooling system 100.

In some embodiments, referring further to FIG. 1, the cooling system 100 further includes the heat exchange apparatus 10. The heat exchange apparatus 10 is arranged in the cooling loop 101 and the heat exchange loop 102 for the cooling loop 101 and the heat exchange loop 102 to exchange heat in the heat exchange apparatus 10.

The heat exchange apparatus 10 refers to a device for exchanging heat. The heat exchange apparatus 10 is arranged in the cooling loop 101 and the heat exchange loop 102, such that the heat exchange apparatus 10 is configured to form the cooling loop 101 and the heat exchange loop 102. The heat exchange apparatus 10 and the pipelines of the cooling system 100 may directly form the cooling loop 101, or the heat exchange apparatus 10, the pipelines of the cooling system 100, the heat generating module 20, and the like may jointly form the cooling loop 101. Correspondingly, the heat exchange apparatus 10 and the pipelines of the cooling system 100 may directly form the heat exchange loop 102, or the heat exchange apparatus 10, the pipelines of the cooling system 100, a cooling tower 22 referred to below, and the like may jointly form the heat exchange loop 102.

When the cooling system 100 is in operation, the heat exchange medium circulates in the heat exchange loop 102, and the coolant liquid circulates in the cooling loop 101. When the coolant liquid flows to the heat exchange apparatus 10, the coolant liquid exchanges heat with the heat exchange medium that flows to the heat exchange apparatus 10 to implement the cooling effect. That is, the coolant liquid in the cooling loop 101 and the heat exchange medium of the heat exchange loop 102 exchange heat in the heat exchange apparatus 10 to implement cooling of the coolant liquid, thereby being beneficial for the coolant liquid to continuously cool the heat generating module 20 at a lower temperature.

Due to such an arrangement, the heat exchange loop 102 and the cooling loop 101 are enabled to exchange heat in the heat exchange apparatus 10, such that the cooling loop 101 can continuously implement cooling for the heat generating module 20.

In some embodiments, referring to FIGs. 1 and 2 together, FIG. 2 is a cross-sectional view of a first heat exchanger 11 of the cooling system 100 provided in FIG. 1. The heat exchange apparatus 10 includes a plurality of first heat exchangers 11. The first heat exchanger 11 is provided with a first flow channel 1101 and a second flow channel 1102. The first flow channel 1101 and the second flow channel 1102 are arranged independent from each other. The first flow channel 1101 is configured to form the cooling loop 101, and the second flow channels 1102 of the plurality of first heat exchangers 11 are configured to form the heat exchange loop 102.

The expression that the first flow channel 1101 is configured to form the cooling loop 101 means that the first flow channel 1101 is one section of the cooling loop 101. When the coolant liquid circulates in the cooling loop 101, the coolant liquid flows into the first flow channel 1101, exchanges heat with the heat exchange medium in the second flow channel 1102, and then flows out of the first flow channel 1101. The first flow channel 1101 and the pipelines of the cooling system 100 may directly form the cooling loop 101, or the first flow channel 1101, the pipelines of the cooling system 100, the heat generating module 20, and the like may jointly form the cooling loop 101.

Correspondingly, the expression that the second flow channel 1102 is configured to form the heat exchange loop 102 means that the second flow channel 1102 is one section of the heat exchange loop 102. When the heat exchange medium flows in the heat exchange loop 102, the heat exchange medium flows into the second flow channel 1102, exchanges heat with the coolant liquid in the first flow channel 1101, and then flows out of the second flow channel 1102. The second flow channel 1102 and the pipelines of the cooling system 100 may directly form the heat exchange loop 102, or the second flow channel 1102, the pipelines of the cooling system 100, the cooling tower 22 referred to below, and the like may jointly form the heat exchange loop 102.

The first flow channel 1101 and the second flow channel 1102 are arranged independent from each other, such that the heat exchange loop 102 and the cooling loop 101 are independent from each other, and thus the cooling loop 101 can continuously implement cooling for the heat generating module 20, while the heat exchange loop 102 can continuously implement the cooling for the cooling loop 101.

The number of the first heat exchangers 11 may be the same as the number of the cooling loops 101, and the first heat exchangers 11 and the cooling loops 101 are arranged in a one-to-one correspondence. Each first heat exchanger 11 is arranged in a corresponding cooling loop 101, and the first flow channel 1101 of each first heat exchanger 11 is configured to form the corresponding cooling loop 101.

For ease of description, it is assumed that two of the cooling loops 101 are a first cooling loop 101a and a second cooling loop 101b, respectively, two of the first heat exchangers 11 are a No. 1 first heat exchanger 11a and a No. 2 first heat exchanger 11b, respectively, and two of the heat generating modules 20 are a first heat generating module 20a and a second heat generating module 20b, respectively. The first heat generating module 20a and the No. 1 first heat exchanger 11a are arranged in the first cooling loop 101a, and the second heat generating module 20b and the No. 2 first heat exchanger 11b are arranged in the second cooling loop 101b.

When the cooling system 100 is in operation, the coolant liquid circulates in each cooling loop 101 to cool the corresponding heat generating module 20. That is, the coolant liquid in the first cooling loop 101a is configured to cool the first heat generating module 20a, and the coolant liquid in the second cooling loop 101b is configured to cool the second heat generating module 20b. Meanwhile, the heat exchange medium circulates in the heat exchange loop 102. Specifically, the heat exchange medium sequentially passes through the plurality of first heat exchangers 11 during circulation. The heat exchange medium first flows into the second flow channel 1102 of the No. 1 first heat exchanger 11a, and the coolant liquid in the first cooling loop 101a first flows into the first flow channel 1101 of the No. 1 first heat exchanger 11a to exchange heat with the heat exchange medium in the second flow channel 1102 of the No. 1 first heat exchanger 11a, and then flows out of the first flow channel 1101. Then, the heat exchange medium flows from the second flow channel 1102 of the No. 1 first heat exchanger 11a to the second flow channel 1102 of the No. 2 first heat exchanger 11b, and the coolant liquid in the second cooling loop 101b first flows into the first flow channel 1101 of the No. 2 first heat exchanger 11b to exchange heat with the heat exchange medium in the second flow channel 1102 of the No. 2 first heat exchanger 11b, and then flows out of the first flow channel 1101 of the No. 2 first heat exchanger 11b. Based on this, the heat exchange loop 102 sequentially exchanges heat with the plurality of cooling loops 101.

Due to such an arrangement, the heat exchange loop 102 is enabled to exchange heat with each cooling loop 101, such that each cooling loop 101 can continuously implement cooling for the corresponding heat generating module 20.

In some embodiments, referring further to FIGs. 1 and 2, the flow direction of the coolant liquid in the first flow channel 1101 of the first heat exchanger 11 is opposite to the flow direction of the heat exchange medium in the second flow channel 1102 of the first heat exchanger 11, such that the coolant liquid can better exchange heat with the heat exchange medium, thereby facilitating improving the heat exchange efficiency and effect.

In some embodiments, referring further to FIG. 2, the first heat exchanger 11 may be, but is not limited to, a plate heat exchanger, and the first flow channel 1101 and the second flow channel 1102 are sequentially distributed in the thickness direction of the first heat exchanger 11, such that the first flow channel 1101 and the second flow channel 1102 have a larger heat exchange area, which thus can improve the heat exchange efficiency and heat exchange effect.

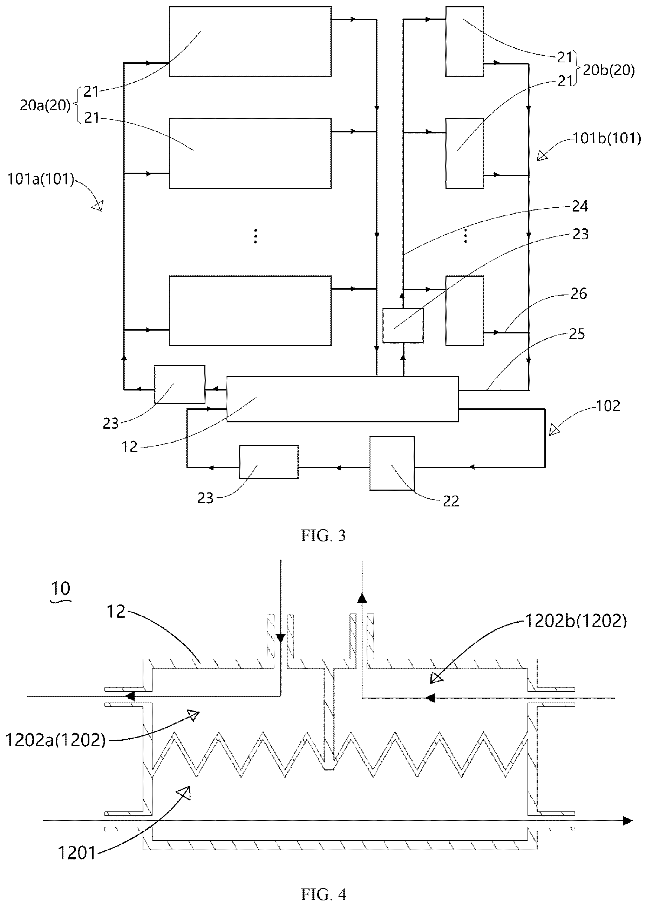

In some embodiments, referring to FIGs. 3 and 4 together, FIG. 3 is a schematic view of a cooling system 100 according to some other embodiments of the present application, and FIG. 4 is a cross-sectional view of a second heat exchanger 12 of the cooling system 100 provided in FIG. 3. The heat exchange apparatus 10 includes the second heat exchanger 12. The second heat exchanger 12 is provided with a third flow channel 1201 and a plurality of fourth flow channels 1202. The third flow channel 1201 and the plurality of fourth flow channels 1202 are arranged independent from each other. The third flow channel 1201 is configured to form the heat exchange loop 102, and the fourth flow channel 1202 is configured to form the cooling loop 101.

The expression that the third flow channel 1201 is configured to form the heat exchange loop 102 means that the third flow channel 1201 is one section of the heat exchange loop 102. When the heat exchange medium flows in the heat exchange loop 102, the heat exchange medium flows into the third flow channel 1201, exchanges heat with the coolant liquid in the fourth flow channel 1202, and then flows out of the third flow channel 1201. The third flow channel 1201 and the pipelines of the cooling system 100 may directly form the heat exchange loop 102, or the third flow channel 1201, the pipelines of the cooling system 100, the cooling tower 22 referred to below, and the like may jointly form the heat exchange loop 102.

Correspondingly, the expression that the fourth flow channel 1202 is configured to form the cooling loop 101 means that the fourth flow channel 1202 is one section of the cooling loop 101. When the coolant liquid circulates in the cooling loop 101, the coolant liquid flows into the fourth flow channel 1202, exchanges heat with the heat exchange medium in the third flow channel 1201, and then flows out of the fourth flow channel 1202. The fourth flow channel 1202 and the pipelines of the cooling system 100 may directly form the cooling loop 101, or the fourth flow channel 1202, the pipelines of the cooling system 100, the heat generating module 20, and the like may jointly form the cooling loop 101.

The second heat exchanger 12 is arranged in the heat exchange loop 102 and the plurality of cooling loops 101. The second heat exchanger 12 is provided with the plurality of fourth flow channels 1202, and each fourth flow channel 1202 is configured to form a corresponding cooling loop 101. In addition, the heat exchange medium in the fourth flow channel 1202 may exchange heat with the coolant liquid in each third flow channel 1201; that is, the heat exchange medium in the fourth flow channel 1202 may implement cooling of the coolant liquid in each third flow channel 1201, such that the heat exchange loop 102 can implement the cooling effect of each cooling loop 101.

The plurality of fourth flow channels 1202 are arranged independent from each other, such that the plurality of cooling loops 101 are independent from each other. The third flow channel 1201 and the fourth flow channel 1202 are arranged independent from each other, such that the heat exchange loop 102 and the cooling loop 101 are independent from each other.

For ease of description, it is assumed that two of the cooling loops 101 are a first cooling loop 101a and a second cooling loop 101b, respectively, two of the heat generating modules 20 are a first heat generating module 20a and a second heat generating module 20b, respectively, the first heat generating module 20a is arranged in the first cooling loop 101a, the second heat generating module 20b is arranged in the second cooling loop 101b, and the second heat exchanger 12 is arranged in the first cooling loop 101a, the second cooling loop 101b, and the heat exchange loop 102. Based on this, the number of the fourth flow channels 1202 is two, the two fourth flow channels 1202 are a No. 1 fourth flow channel 1202a and a No. 2 fourth flow channel 1202b, respectively, the No. 1 fourth flow channel 1202a is configured to form the first cooling loop 101a, and the No. 2 fourth flow channel 1202b is configured to form the second cooling loop 101b.

When the cooling system 100 is in operation, the coolant liquid circulates in each cooling loop 101 to cool the corresponding heat generating module 20. That is, the coolant liquid in the first cooling loop 101a cools the first heat generating module 20a, and the coolant liquid in the second cooling loop 101b cools the second heat generating module 20b. Meanwhile, the heat exchange medium circulates in the heat exchange loop 102, and the heat exchange medium may flow to the third flow channel 1201. The coolant liquid in the first cooling loop 101a first flows into the No. 1 fourth flow channel 1202a of the second heat exchanger 12 to exchange heat with the heat exchange medium in the third flow channel 1201, and then flows out of the No. 1 fourth flow channel 1202a. The coolant liquid in the second cooling loop 101b first flows into the No. 2 fourth flow channel 1202b of the second heat exchanger 12 to exchange heat with the heat exchange medium in the third flow channel 1201, and then flows out of the No. 2 fourth flow channel 1202b. Based on this, the heat exchange medium in the third flow channel 1201 may exchange heat with the coolant liquid in the plurality of fourth flow channels 1202, such that the heat exchange loop 102 can achieve the effect of heat exchange with each cooling loop 101.

Due to such an arrangement, the heat exchange loop 102 is enabled to exchange heat with each cooling loop 101, such that each cooling loop 101 can continuously implement cooling for the corresponding heat generating module 20. In addition, by arranging only one second heat exchanger 12, the heat-exchange cooling effect of the heat exchange loop 102 for the plurality of cooling loops 101 can be achieved, such that the structure of the cooling system 100 is enabled to be very simple.

In some embodiments, referring further to FIGs. 3 and 4, the flow direction of the coolant liquid in the fourth flow channel 1202 is opposite to the flow direction of the heat exchange medium in the third flow channel 1201, such that the coolant liquid can better exchange heat with the heat exchange medium, thereby facilitating improving the heat exchange efficiency and effect.

In some embodiments, referring to FIGs. 1 and 3 together and in combination with other drawings, the heat exchange apparatus 10 and the heat generating module 20 form the cooling loop 101.

It can be understood that the heat generating module 20, the pipelines of the cooling system 100, and the heat exchange apparatus 10 jointly form the cooling loop 101.

When the cooling loop 101 is in operation, the coolant liquid sequentially passes through the heat generating module 20 and the heat exchange apparatus 10, thereby cooling the heat generating module 20 in sequence and implementing cooling through heat exchange of the heat exchange apparatus 10.

Due to such an arrangement, the structure of the cooling system 100 is enabled to be very simple.

Alternatively, in some embodiments, the cooling system 100 further includes a third heat exchanger, and the heat exchange apparatus 10 and the third heat exchanger form the cooling loop 101. The heat generating module 20 is arranged on the third heat exchanger, such that the third heat exchanger is configured to exchange heat with the heat generating module 20.

When the cooling loop 101 is in operation, the coolant liquid may flow to the third heat exchanger, thereby implementing heat exchange with the heat generating module 20 through the third heat exchanger to implement cooling for the heat generating module 20.

Due to such an arrangement, the cooling loop 101 is enabled to implement cooling for the heat generating module 20.

In some embodiments, referring to FIGs. 1 and 3 together and in combination with other drawings, two of the heat generating modules 20 are a first heat generating module 20a and a second heat generating module 20b, respectively. The first heat generating module 20a includes a battery, and the second heat generating module 20b includes a converter.

It can be understood that two of the cooling loops 101 are a first cooling loop 101a and a second cooling loop 101b, respectively. The first heat generating module 20a is arranged in the first cooling loop 101a, and the first cooling loop 101a is configured to cool the first heat generating module 20a, i.e., configured to cool the battery. The second heat generating module 20b is arranged in the second cooling loop 101b, and the second cooling loop 101b is configured to cool the second heat generating module 20b, i.e., configured to cool the converter.

Based on the fact that the flow rate of the coolant liquid required by the battery is greater than that of the converter, the first cooling loop 101a may be set to allow the coolant liquid with the flow rate greater than that of the second cooling loop 101b to pass through, such that the flow rate of the coolant liquid in the first cooling loop 101a can match the battery, and the flow rate of the coolant liquid in the second cooling loop 101b can match the converter. Correspondingly, the pressure of the coolant liquid in the first cooling loop 101a may also match the battery, and the pressure of the coolant liquid in the second cooling loop 101b may also match the converter.

Due to such an arrangement, the cooling system 100 is enabled to be configured to cool the battery and the converter, and the battery and the converter can be cooled through different cooling loops 101. In this way, the flow rate and pressure of the coolant liquid required by the battery can match those of the coolant liquid in the corresponding cooling loop 101, and the flow rate and pressure of the coolant liquid required by the converter can also match those of the coolant liquid in the corresponding cooling loop 101, thereby being capable of alleviating the problem that it is difficult to match the pressure and flow rate of the coolant liquid with the plurality of heat generating modules 20, and facilitating achieving a good cooling effect for the battery and the converter.

In some embodiments, referring to FIGs. 1 and 3 together and in combination with other drawings, two of the cooling loops 101 are a first cooling loop 101a and a second cooling loop 101b, respectively. The first heat generating module 20a is arranged in the first cooling loop 101a, and the second heat generating module 20b is arranged in the second cooling loop 101b. The cooling system 100 further includes a heat exchange loop 102. The heat exchange loop 102 and the cooling loop 101 are arranged independent from each other, and the heat exchange loop 102 is configured to exchange heat with each cooling loop 101. The first cooling loop 101a and the second cooling loop 101b are sequentially arranged in the circulation direction of the heat exchange medium in the heat exchange loop 102.

It should be noted that the first heat generating module 20a includes a battery, and the second heat generating module 20b includes a converter. The first cooling loop 101a is configured to cool the battery, and the second cooling loop 101b is configured to cool the converter.

When the cooling system 100 is in operation, the coolant liquid in the first cooling loop 101a cools the battery and heats up, and the coolant liquid in the second cooling loop 101b cools the converter and heats up. The temperature of the heat exchange medium required by the coolant liquid in the first cooling loop 101a is lower than the temperature of the heat exchange medium required by the coolant liquid in the second cooling loop 101b.

When the cooling system 100 is in operation, the heat exchange medium circulates in the heat exchange loop 102. The heat exchange medium first passes through the first cooling loop 101a and exchanges heat with the first cooling loop 101a to implement cooling for the first cooling loop 101a. Then, the heat exchange medium passes through the second cooling loop 101b and exchanges heat with the second cooling loop 101b to implement cooling for the second cooling loop 101b. As such, the heat exchange medium may first exchange heat with the coolant liquid in the first cooling loop 101a, and then exchange heat with the coolant liquid in the second cooling loop 101b; that is, the temperature of the heat exchange medium when exchanging heat with the first cooling loop 101a is lower than the temperature of the heat exchange medium when exchanging heat with the second cooling loop 101b.

In this way, compared with the second cooling loop 101b, the coolant liquid in the first cooling loop 101a can exchange heat with the heat exchange medium having a lower temperature, such that the cooling operation for the battery can be better achieved.

In some embodiments, referring to FIGs. 1 and 3 together and in combination with other drawings, the heat generating module 20 includes a plurality of heat generating elements 21, and the plurality of heat generating elements 21 are arranged in the cooling loop 101 in parallel through pipelines.

It can be understood that the cooling loop 101 is provided with a first main pipeline 24, a second main pipeline 25, and a plurality of branch pipelines 26. The first main pipeline 24 and the second main pipeline 25 are connected to the heat exchange apparatus 10 to be in communication with each other through the first flow channel 1101 or the fourth flow channel 1202 of the heat exchange apparatus 10. Both ends of each branch pipeline 26 are in communication with the first main pipeline 24 and the second main pipeline 25, and the plurality of heat generating elements 21 are respectively arranged on the plurality of branch pipelines 26. In addition, the first main pipeline 24, the second main pipeline 25, and the plurality of branch pipelines 26 form the cooling loop 101.

Based on this, the coolant liquid may flow from the heat exchange apparatus 10 to the first main pipeline 24, and then divert to the plurality of branch pipelines 26, and the coolant liquid in each branch pipeline 26 is configured to cool the heat generating element 21 on each branch pipeline 26. Subsequently, the coolant liquid in the plurality of branch pipelines 26 converges into the second main pipeline 25 and flows to the heat exchange apparatus 10 to exchange heat with the heat exchange loop 102, and then flows to the first main pipeline 24, and so on.

When the heat generating module 20 is the first heat generating module 20a, the plurality of heat generating elements 21 of the first heat generating module 20a are batteries; that is, the plurality of batteries are arranged in the cooling loop 101 in parallel through pipelines. When the heat generating module 20 is the second heat generating module 20b, the plurality of heat generating elements 21 of the second heat generating module 20b are converters; that is, the plurality of converters are arranged in the cooling loop 101 in parallel through pipelines.

Due to such an arrangement, the coolant liquid in the cooling loop 101 is enabled to flow in parallel to the plurality of heat generating elements 21 to cool the plurality of heat generating elements 21, thereby being capable of improving the effect of the cooling loop 101 in cooling the heat generating module 20.

In some embodiments, referring to FIGs. 1 and 3 together and in combination with other drawings, the heat exchange loop 102 is provided with a cooling tower 22.

The cooling tower 22 refers to a device for cooling the heat exchange medium.

It can be understood that the heat exchange apparatus 10, the cooling tower 22, and the pipelines of the cooling system 100 form the heat exchange loop 102. The heat exchange medium may first pass through the heat exchange apparatus 10, thereby exchanging heat with the coolant liquid in the cooling loop 101 in the second flow channel 1102 or the third flow channel 1201 of the heat exchange apparatus 10, such that the temperature is enabled to rise. Then, the heat exchange medium flows to the cooling tower 22 and is cooled by the cooling tower 22. Subsequently, the cooled heat exchange medium flows to the heat exchange apparatus 10 again to exchange heat with the coolant liquid, and so on.

In this way, when circulating in the heat exchange loop 102, the heat exchange medium can be continuously cooled by the cooling tower 22 and exchange heat with the cooling loop 101, such that heat-exchange cooling for the cooling loop 101 can be continuously implemented, thereby being beneficial for the coolant liquid in the cooling loop 101 to continuously implement cooling for the heat generating module 20.

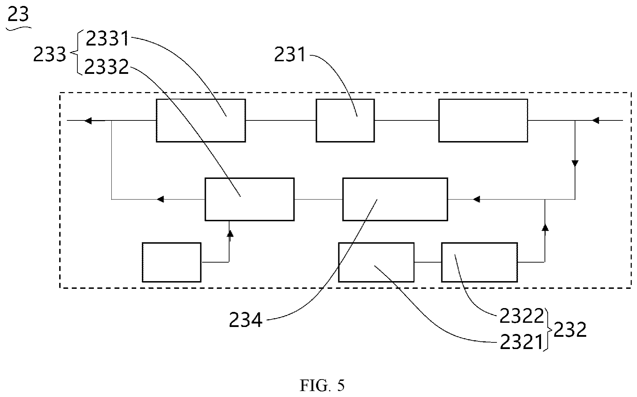

In some embodiments, referring to FIGs. 1, 3, and 5 together and in combination with other drawings, FIG. 5 is a schematic view of a treatment apparatus 23 of the cooling system 100 according to some embodiments of the present application. The cooling loop 101 is provided with the treatment apparatus 23. Alternatively, the heat exchange loop 102 is provided with the treatment apparatus 23. Alternatively, both the cooling loop 101 and the heat exchange loop 102 are provided with the treatment apparatus 23.

Specifically, the treatment apparatus 23 includes at least one of a pumping apparatus 231, a flow meter, a water replenishing apparatus 232, a pressure gauge, a gas pressure balancing apparatus 233, and an ion exchanger 234.

The pumping apparatus 231 refers to an apparatus having a pumping capability and may be, but is not limited to, a pressure pump.

The flow meter refers to an apparatus for detecting the flow rate.

The water replenishing apparatus 232 refers to an apparatus that replenishes a medium (a coolant liquid or a heat exchange medium) based on the flow rate detected by the flow meter. The water replenishing apparatus 232 may include a raw water tank 2321 and a water replenishing pump 2322. The water replenishing pump 2322 may pump the medium (the coolant liquid or the heat exchange medium) in the raw water tank 2321 to the loop (the cooling loop 101 or the heat exchange loop 102).

The pressure gauge refers to an apparatus for detecting the pressure.

The gas pressure balancing apparatus 233 refers to an apparatus for performing degassing and replenishing gas to balance the gas pressure, and may be, but is not limited to, a degassing tank 2331 and an expansion tank 2332.

The ion exchanger 234 refers to an apparatus that can adsorb and eliminate conductive ions of the medium (the coolant liquid or the heat exchange medium).

For the treatment apparatus 23 of the heat exchange loop 102, the pumping apparatus 231 may pump the heat exchange medium in the heat exchange loop 102 to implement circulation of the heat exchange medium in the heat exchange loop 102. The flow meter may detect the flow rate of the heat exchange medium, and the water replenishing apparatus 232 may replenish the heat exchange medium based on the flow rate value detected by the flow meter, such that the flow rate of the heat exchange medium in the heat exchange loop 102 can be balanced and stable. The pressure gauge may detect the pressure in the heat exchange loop 102. The gas pressure balancing apparatus 233 may perform degassing or replenish gas based on the pressure value detected by the pressure gauge to implement gas pressure balance in the heat exchange loop 102. The ion exchanger 234 can adsorb and eliminate the conductive ions in the heat exchange medium, thereby being capable of alleviating the problem of pipeline corrosion of the cooling system 100.

For the treatment apparatus 23 of the cooling loop 101, the pumping apparatus 231 may pump the coolant liquid in the cooling loop 101 to implement circulation of the coolant liquid in the cooling loop 101. The flow meter may detect the flow rate of the coolant liquid, and the water replenishing apparatus 232 may replenish the coolant liquid based on the flow rate value detected by the flow meter, such that the flow rate of the coolant liquid in the cooling loop 101 can be balanced and stable. The pressure gauge may detect the pressure in the cooling loop 101. The gas pressure balancing apparatus 233 may perform degassing or replenish gas based on the pressure value detected by the pressure gauge to implement gas pressure balance in the cooling loop 101. The ion exchanger 234 can adsorb and eliminate the conductive ions in the coolant liquid. In one aspect, the problem of pipeline corrosion of the cooling system 100 can be alleviated. In another aspect, insulation can be implemented, and the potential difference can be eliminated, thereby improving the safety performance.

As an example, as shown in FIG. 5, the degassing tank 2331 of the gas pressure balancing apparatus 233 and the pumping apparatus 231 may be sequentially arranged in the heat exchange loop 102 or the cooling loop 101 through pipelines, and may be specifically arranged in the first main pipeline 24, the second main pipeline 25, or the branch pipeline 26, or may be respectively arranged in at least two of the first main pipeline 24, the second main pipeline 25, and the branch pipeline 26. The expansion tank 2332 of the gas replenishing apparatus, the ion exchanger 234, and the water replenishing apparatus 232 may be arranged through pipelines in sequence. In addition, the integrated unit formed by sequentially connecting the degassing tank 2331 of the gas replenishing apparatus and the pumping apparatus 231 and the integrated unit formed by connecting the expansion tank 2332 of the gas replenishing apparatus, the ion exchanger 234, and the water replenishing apparatus 232 in sequence through pipelines are arranged in parallel through pipelines.

By arranging the treatment apparatus 23 in the cooling loop 101 and/or the heat exchange loop 102, the cooling loop 101 is enabled to stably implement the cooling operation for the heat generating module 20, and/or the heat exchange loop 102 is enabled to stably implement heat exchange with the cooling loop 101, such that the cooling system 100 can stably implement the cooling operation for the heat generating module 20.

Based on the above concept, an embodiment of the present application further provides an energy storage power station. The energy storage power station includes a cooling system 100. The cooling system 100 in this embodiment is the same as the cooling system 100 in the previous embodiment. Reference may be made to the relevant descriptions of the cooling system 100 in the previous embodiment for details, which are not described again herein.

According to the energy storage power station provided in the embodiment of the present application, by adopting the cooling system 100 involved above, both a flow rate and pressure of a coolant liquid passing through each heat generating module 20 can match the heat generating module 20; that is, the problem that it is difficult to match the pressure and flow rate of the coolant liquid with a plurality of heat generating modules 20 can be alleviated, thereby facilitating achieving a good cooling effect for the plurality of heat generating modules 20.

As one embodiment of the present application, as shown in FIGs. 1 to 4, the cooling system 100 includes a heat exchange apparatus 10, a first heat generating module 20a, a second heat generating module 20b, and a cooling tower 22. The heat exchange apparatus 10 and the cooling tower 22 form a heat exchange loop 102, the heat exchange apparatus 10 and the first heat generating module 20a form a first cooling loop 101a, and the heat exchange apparatus 10 and the second heat generating module 20b form a second cooling loop 101b. The first cooling loop 101a, the second cooling loop 101b, and the heat exchange loop 102 are arranged independent from each other. A coolant liquid may circulate in both the first cooling loop 101a and the second cooling loop 101b, and a heat exchange medium may circulate in the heat exchange loop 102. During operation, the coolant liquid in the first cooling loop 101a circulates in the first cooling loop 101a to cool the first heat generating module 20a, and the coolant liquid in the first cooling loop 101a exchanges heat with the heat exchange medium in the heat exchange apparatus 10 to implement cooling of the coolant liquid, such that the coolant liquid can continuously cool the first heat generating module 20a while circulating. The coolant liquid in the second cooling loop 101b circulates in the second cooling loop 101b to cool the second heat generating module 20b, and the coolant liquid in the second cooling loop 101b exchanges heat with the heat exchange medium in the heat exchange apparatus 10 to implement cooling of the coolant liquid, such that the coolant liquid can continuously cool the second heat generating module 20b while circulating. When circulating in the heat exchange loop 102, the heat exchange medium may flow to the heat exchange apparatus 10 and exchange heat with the coolant liquid in the first cooling loop 101a to cool the coolant liquid in the first cooling loop 101a, such that the coolant liquid in the first cooling loop 101a can continuously cool the first heat generating module 20a, and may also flow to the heat exchange apparatus 10 and exchange heat with the coolant liquid in the second cooling loop 101b to cool the coolant liquid in the second cooling loop 101b, such that the coolant liquid in the second cooling loop 101b can continuously cool the second heat generating module 20b. The heat exchange medium may also flow to the cooling tower 22 to implement cooling, such that the heat exchange medium can continuously exchange heat with the first cooling loop 101a and the second cooling loop 101b while circulating.

The first heat generating module 20a includes a plurality of batteries, and the plurality of batteries are arranged in the first cooling loop 101a in parallel through pipelines. The second heat generating module 20b includes a plurality of converters, and the plurality of converters are arranged in the second cooling loop 101b in parallel through pipelines.

The above descriptions are merely optional embodiments of the present application, and are not intended to limit the present application. For those skilled in the art, the present application can be modified and varied. Any modification, equivalent substitution, improvement, and the like made within the spirit and principle of the present application shall all fall within the scope of the claims of the present application.

## Claims

1. A cooling system (100), comprising:
a plurality of cooling loops (101), arranged independent from each other; and
a plurality of heat generating modules (20), respectively arranged in the plurality of cooling loops (101), wherein the plurality of cooling loops (101) are respectively configured to cool the heat generating modules (20).

2. The cooling system (100) according to claim 1, wherein the cooling system (100) further comprises a heat exchange loop (102) independent from the cooling loops (101), and the heat exchange loop (102) is configured to exchange heat with each cooling loop (101).

3. The cooling system (100) according to claim 2, wherein the cooling system (100) further comprises a heat exchange apparatus (10), the heat exchange apparatus (10) is arranged in the cooling loop (101) and the heat exchange loop (102) for the cooling loop (101) and the heat exchange loop (102) to exchange heat in the heat exchange apparatus (10).

4. The cooling system (100) according to claim 3, wherein the heat exchange apparatus (10) comprises a plurality of first heat exchangers (11), the first heat exchanger (11) is provided with a first flow channel (1101) and a second flow channel (1102) that are independent from each other, the first flow channel (1101) is configured to form the cooling loop (101), and the second flow channels (1102) of the plurality of first heat exchangers (11) are configured to form the heat exchange loop (102).

5. The cooling system (100) according to claim 4, wherein a flow direction of a coolant liquid in the first flow channel (1101) is opposite to a flow direction of a heat exchange medium in the second flow channel (1102).

6. The cooling system (100) according to claim 4 or 5, wherein the first flow channel (1101) and the second flow channel (1102) are sequentially distributed in a thickness direction of the first heat exchanger (11).

7. The cooling system (100) according to claim 3, wherein the heat exchange apparatus (10) comprises a second heat exchanger (12), the second heat exchanger (12) is provided with a third flow channel (1201) and a plurality of fourth flow channels (1202) that are independent from each other, the third flow channel (1201) is configured to form the heat exchange loop (102), and the fourth flow channel (1202) is configured to form the cooling loop (101).

8. The cooling system (100) according to claim 7, wherein a flow direction of a coolant liquid in the fourth flow channel (1202) is opposite to a flow direction of a heat exchange medium in the third flow channel (1201).

9. The cooling system (100) according to any one of claims 3 to 8, wherein the heat exchange apparatus (10) and the heat generating module (20) form the cooling loop (101);
alternatively, the cooling system (100) further comprises a third heat exchanger, the heat exchange apparatus (10) and the third heat exchanger form the cooling loop (101), and the third heat exchanger is configured to exchange heat with the heat generating module (20).

10. The cooling system (100) according to any one of claims 1 to 9, wherein two of the heat generating modules (20) are a first heat generating module (20a) and a second heat generating module (20b), respectively, the first heat generating module (20a) comprises a battery, and the second heat generating module (20b) comprises a converter.

11. The cooling system (100) according to claim 10, wherein two of the cooling loops (101) are a first cooling loop (101a) and a second cooling loop (101b), respectively, the first heat generating module (20a) is arranged in the first cooling loop (101a), and the second heat generating module (20b) is arranged in the second cooling loop (101b);
the cooling system (100) further comprises a heat exchange loop (102) independent from the cooling loops (101), and the heat exchange loop (102) is configured to exchange heat with each cooling loop (101);
the first cooling loop (101a) and the second cooling loop (101b) are sequentially arranged in a circulation direction of the heat exchange medium in the heat exchange loop (102).

12. The cooling system (100) according to any one of claims 1 to 11, wherein the heat generating module (20) comprises a plurality of heat generating elements (21), and the plurality of heat generating elements (21) are arranged in the cooling loop (101) in parallel through pipelines.

13. The cooling system (100) according to any one of claims 2 to 9 or 11, wherein the heat exchange loop (102) is provided with a cooling tower (22).

14. The cooling system (100) according to any one of claims 2 to 9 or 11, wherein the cooling loop (101) and/or the heat exchange loop (102) are/is provided with at least one of a pumping apparatus (231), a flow meter, a water replenishing apparatus (232), a pressure gauge, a gas pressure balancing apparatus (233), and an ion exchanger (234).

15. An energy storage power station, comprising the cooling system (100) according to any one of claims 1 to 14.
